# EUROPEAN PATENT SPECIFICATION

(11) **EP 2 695 204 B1**
(45) Date of publication and mention of the grant of the patent: **18.03.2015**
(21) Application number: 12726183.2
(22) Date of filing: 18.04.2012
(51) Int. Cl.: H01L 31/052, H01L 31/055, H01L 31/042, H01L 31/048

(54) **PHOTOVOLTAIC DEVICE**
PV-ELEMENT
DISPOSITIF PHOTOVOLTAÏQUE

(30) Priority: 11.07.2011 IT RM20110361
(43) Date of publication of application: 12.02.2014
(73) Proprietor: Repetto, Matteo, 16149 Genova - GE (IT)
(72) Inventor: Repetto, Matteo, 16149 Genova - GE (IT)
(74) Representative: Romano, Giuseppe
(86) International application number: PCT/IB2012/051934
(87) International publication number: WO 2013/008105

(56) References cited:
- US-A1- 2007 227 579
- US-A1- 2011 162 711
- ORTABASI U ET AL: "Low concentration photovoltaic module design using bifacial solar cells", 19880926; 19880926 - 19880930, 26 September 1988 (1988-09-26), pages 1324-1326, XP010750716,

## Description

The present invention relates to a photovoltaic device using luminescent solar concentrators for converting solar energy into electric energy. More generally, the invention relates to a photovoltaic panel comprising a plurality of said photovoltaic devices arranged on its surface.

As is known, luminescent solar panels aim to stand out in the photovoltaic market thanks to their compactness, high efficiency and multivalence features.

Observations constituting a starting point to describe the background of said typology of panels relate first of all the pursuit, by the photovoltaic industry, of a containment of the costs of photovoltaic devices (in particular, first-generation ones) as a solution for the spreading of this technology.

Generally speaking, this aim is pursued by adopting three courses of action: reduction of raw matter costs, manufacturing of high-productivity and high-yield lines and increase of photovoltaic device efficiency.

As to the first two courses of action, if on the one hand a decrease of a few percent points is sought for the present-day 14 - 19% that silicon feedstock has on the total cost of the device, by using metallurgical-grade silicon and simplifying its purification techniques in order to limit the use of electronic-grade silicon (essential to reach >20% efficiencies), on the other hand industry strives to decrease the thickness (and therefore the amount) of silicon wafers below the present-day 150 µm by aiming at a marked automation of production lines, which reduce the chance of breakage during cell manufacturing steps and enable specific treatments of the top and bottom surface thereof, such as texturing and back-reflector ones.

However, most of the energies should be focused on the third "course of action".

Latest techniques aim at improving photovoltaic conversion techniques of cells by modifying the external quantum efficiency (EQE) spectrum of silicon in order to make it more compatible with the solar spectrum; i.e., by varying the size of the "quantum dots", which are conducting material particles of sizes of the order of the nanometer, in which the wavelength they absorb or emit is adjustable, or by other two processes which take the name of "up - conversion", when two or more infrared photons reach a specific component called "up - converter", positioned on the rear side of the cell, thereby making an electron jump into a higher-energy level, or of "down-shifting" when for each incident high-energy electron mo re than one photon of lesser energy is generated.

Second-generation (thin film, introduced to simplify and make more economical the production process) and third-generation photovoltaic (PV) technologies, in which chemical-organic-based materials come to the fore and whose main examples are dye-sensitized solar cells (or Grätzel cells) and completely organic cells (OPV), also fit in this overview.

Even more than the second-generation photovoltaic field, the next one will witness a leading role of nanotechnologies because, upon reaching sizes of the order of nanometers, peculiar properties or chemico-physical effects are had, perfectly interpretable in quantum terms.

Among these effects, we mention the change of nanoparticles absorption and emission spectrum with the change of sizes, exploitable for manufacturing fluorescent solar concentrators.

These concentrators are made of plates of optically transparent material, inside which luminescent substances (nanoparticles, fluorescent molecules) are dispersed. Hence, the effect of spectral conversion (down-shifting) to low frequencies is exploited, to match the solar spectrum with that maximizing cell efficiency, combined with the waveguide effect of the plate.

Solar radiation absorbed by the broad top surface of the plate is converted into the appropriate spectral range and concentrated at the edges, where small-surface solar cells are placed; this reduces the use of photovoltaic material as adopted in traditional concentration systems.

In LSCs (Luminescent Solar Concentrators) the ratio between receiving surface of the plate and surface of edges thereof represents the gain factor of the concentrator. E.g., a square plate having a 10-cm side and a 5-mm thickness with 4 cells placed at the edges has a gain factor of 5; the same plate, with one cell on a single edge and 3 reflecting mirrors on the remaining edges, has a gain factor of 20. The greater the gain factor, the better the incidence of LSCs in the cost-benefit ratio.

In 2008, JRC's ESTI laboratories at Ispra tested a high-efficiency LSC module, recording a 7.1% value under standard conditions, currently the highest for this kind of devices.

Said module is a 5 x 5 x 0.5 cm³ concentrator made of polymethyl methacrylate, obtained from polymerization of plexitt 55 mixture available on the market. The fluorescent dye used was obtained from a mixture of perylene and curarine. The active portion of the concentrator is comprised of four 5 x 0.5 cm³ gallium arsenide (GaAs) PV cells, placed on plate edges: a PE399 Kristalflex™ film guarantees optics-cells connection without refraction index change.

As shown in the literature, and also in ESTI laboratories, LSC concentrators receive both direct and diffuse solar radiation. In particular, they show a better response (cosine) with respect to standard flat panel-type modules.

For this reason, sun followers as in traditional concentrators would not be necessary.

It is known that light cannot be completely converted into electric energy. Some photons do not have energy sufficing to initiate the photoelectric effect, others instead have energy in excess which goes wasted.

In the case of silicon, all photons having a >1.11 µm wavelength cannot produce photoelectric effect, since their energy is lower than the gap energy (1.12 eV) needed just for silicon. Instead, photons having a <1.11 µm wavelength can develop said effect but only convert 1.12 eV. When they have a greater energy, this is not converted and turns into heat.

In the case of silicon, 30.2% of energy is lost due to incapacity to subtract more than 1.12 eV from the photon, and 20.2% thereof is lost because photons do not possess energy sufficient to originate photoelectric effect. As is known in the literature, maximum energy available is therefore about 49.6%.

US2001/162711 discloses a photovoltaic device with a luminescent layer which convert the UV radiation into light.

The present invention, always using common silicon as material, aims at exploiting, as it will be detailed hereinafter, as much as possible the remaining about 50% of unused solar radiation.

According to an aspect of the invention, such a result is made possible by the use of luminescent solar concentrators; those, when suitably selected, are able to capture photons with greater and shorter wavelength, to then release it with a wavelength appropriate to silicon.

They represent a sort of up - converter and down - shifter with more affordable prices.

Such an object is achieved by a photovoltaic device as substantially defined in claim 1 and by a photovoltaic panel as substantially defined within the scope of claim 21.

Further features of the invention are defined in the corresponding dependent claims thereof.

The present invention, by overcoming the mentioned problems of the known art, entails numerous evident advantages.

As is widely known in the current state of the art, the accumulator is the component of the photovoltaic system guaranteeing the ability to adequately meet power demand by the load; its role is that of integrating the power delivered by the photovoltaic system in case it be exceeded by load demand, and to directly power-supply the load overnight.

A correct sizing has the object of defining the configuration of the battery fleet able to best meet power demand by the load.

Currently, the market allows to choose between two groups: lead-acid accumulators or Nickel-Cadmium accumulators.

Since energy accumulation in photovoltaic systems is required and almost due, it can be improved by compacting their sizes.

Herein, "compacting their sizes" does not mean not taking into account the load it has to meet, but rather making the panel work also on occasions on which usually batteries are supplying the power, as in night-time.

According to a preferred aspect of the present invention, even in the absence of sunlight, photoelectric effect can anyhow be generated, with decreasing intensity along the entire nigh-time span, making unnecessary - for those times - the use of accumulators.

To optimize results, both in terms of power efficiency and composition, integration needs to be envisaged right from the beginning of the designing procedure. Several demands lead to photovoltaic integration: energy saving, environmental protection, image demands, and demands of educational and demonstrative nature. Photovoltaic integration can be subdivided into three categories: retrofitting interventions, interventions on new buildings and on street furniture elements.

The present invention, though waiving a greater integrative capacity typical of third-generation photovoltaics, in the field of architectonical integration might represent a solution in retrofitting interventions, i.e. when the PV system is integrated in buildings already existing, and on street furniture, as the necessary encumbrances - required power being equal - would remain more reasonable for general sizes, and therefore would have a greater chance of "blending" into the structure.

Among the main advantages linked to the present invention there may be mentioned:
- greater overall compactness;
- as to retrofitting and street furniture, improved architectural integration with respect to classic panels;
- potential downsizing of the battery fleet;
- improved exploiting of solar radiation;
- power increase with respect to classic panels;
- night-time operation.

Concerning night-time operation, LSCs act as luminescence diffusing centers, where part of the incident solar spectrum is absorbed and re-emitted under concentration by fluorescence at a higher wavelength.

LSCs are comprised of specific inorganic pigments causing the above-described effects.

Night-time operation would be given when to fluorescence emission be combined, in the same LSC, also phosphorescence emission, i.e. the ability to release previously absorbed light, gradually and under darkness conditions. Of course, to do this the right balance is necessary in mixing the pigments with these features.

The photovoltaic device subject-matter of present invention is comprised, as will be detailed hereinafter in connection to a preferred embodiment thereof given herein by way of example and not for limitative purposes, of:
- a container inside which the device is supported, which preferably has a reasonable width and a markedly flattened curvature, for encumbrance reasons;
- a ring-like structure, comprised, for the external half, of a trapezoidal LSC configured for collecting ultraviolet, and, for the internal half, of a trapezoidal LSC configured for collecting infrared. At the center of the ring, throughout its peripheral development, there is a layer of nanostructured silicon, on the bottom portion of which the contacts are housed. On the top and bottom caps, preferably covering about 30% of the ring surface, mirrors are positioned to convey photons - already concentrated by the container - to the silicon layer so as to obtain photoelectric effect.
- a photovoltaic panel, comprising a movable structure on which the aforesaid photovoltaic devices are installed. It is preferably comprised of a rigid frame, inside which splines of the same material are hinged, able to tilt and rotate about their own axis of 180° in order to give to the structure sun follower abilities. The motion remains within calculated measurements - so as not to affect the encumbrance increase.

The motion adjusting mechanism has to be placed at the internal ends of the central strip and then connected with the other ones.

The number of splines and concentrators is variable, but the standard might be of 4 strips for 8 concentrators.

Besides the modularity linked to the possibility of selecting the number of usable luminescent solar concentrators, there is that linked to the possibility of fixing the entire panel (therefore, all the aforesaid frame) on mechanical joints or brackets able to guarantee its motion; an example might be given by the fixing on joints making the panel "retractable", to then position it under balconies, rather than on protection "railings" thereof, avoiding a conditioning of the aesthetics of buildings structures, e.g. of historical relevance.

The present invention would propose itself on the market by introducing very interesting and peculiar aspects, setting itself as a valid solution both for stand-alone and grid-connected systems.

In this, it would be assisted first of all by its reduced encumbrance with respect to classic panels, giving to holders of isolated subscriptions or city dwellers much more freedom of action in panel positioning, fostering the most peculiar solutions in order to least affect structures; thereafter, it would be assisted also by its modularity since, as mentioned hereto, the standard size might be accompanied by all peculiar solutions needed or required by customers. (e.g.: 2 strips - 4 concentrators, or 5 strips and 10 concentrators).

Moreover, it would be the first panel able to produce electric energy also by night-time; this aspect would bring about benefits in terms of battery fleet sizing for isolated subscriptions and of energy credit for mains-connected (city) subscriptions; without taking into account the higher usable power, obtainable thanks to the union between solar concentration and a simple sun-following system, able to move the panel nearer to an optimum tilt for gathering solar radiation.

Its usefulness would show in a two-fold manner in the so-called street furniture: noise barriers, platform roofs, signalling systems, street lamps, maritime signalling systems, bus shelters, parking meters, as such structures could be power-supplied with a part of the energy, while a remaining part thereof (or all of it, in the case of noise barriers) could return to the network, behaving as a sort of grid-connected device. In light of the above, the present invention proposes a photovoltaic device and panel technically advanced, mechanically innovative and ecologically and energetically competitive with respect to traditional energy sources.

### Brief description of the drawings

Still further advantages, as well as the features and the operation steps of the present invention will be made evident in the following detailed description of a preferred embodiment thereof, given by way of example and not for limitative purposes. Reference will be made to the figures of the annexed drawings, wherein:
Figure 1 depicts in a prospective view a photovoltaic device according to the present invention in cross section;
Figures 2 and 5 show in a front view a detail of the section of Figure 1;
Figure 3 shows in a perspective view the photovoltaic device according to the present invention;
Figure 4 shows the photovoltaic device of Figure 3 in a plan view;
Figure 6 shows in a perspective view a photovoltaic panel according to the present invention; and
Figure 7 shows a photovoltaic panel according to a variant embodiment; and
Figures 8A-8C show a sequence of use of the panel of Figure 7.

### Detailed description of the drawings

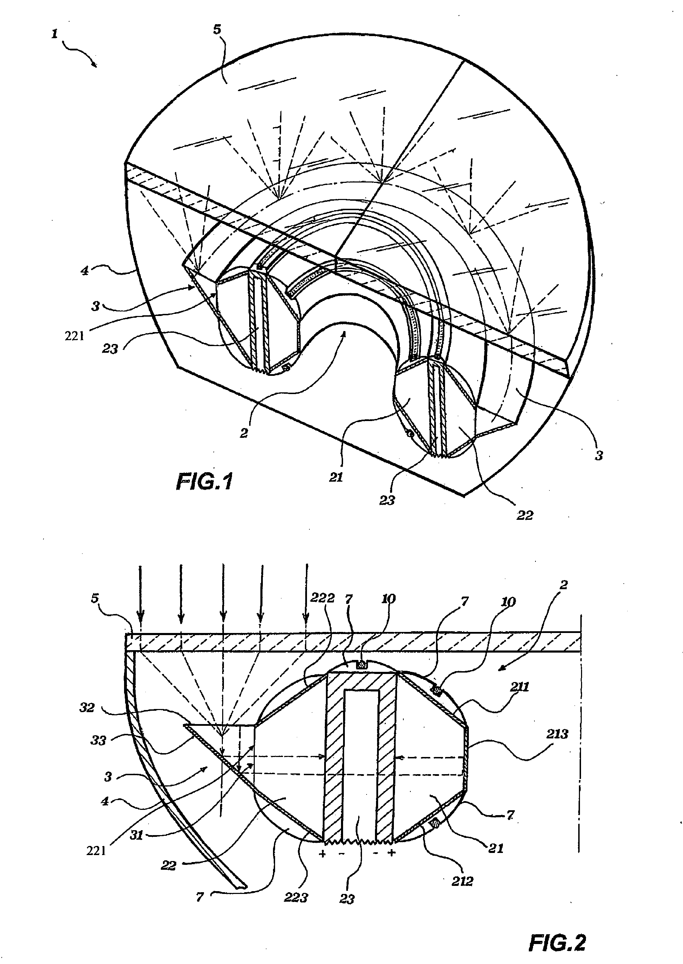

Referring to Figure 1, a photovoltaic device 1 according to the invention, comprising a solar concentrator 2 having a ring-like shape, is shown. In the figure, the concentrator 2 is shown in cross section, therefore only one-half thereof is depicted.

In particular, the concentrator 2 comprises an external luminescent plate (22), arranged along an external portion of the ring and having a trapezoidal section, and an internal luminescent plate (21) arranged in turn along an internal portion of the ring, it also having a trapezoidal section.

The device 1 further comprises a layer 23 of semiconductor material, preferably of nanostructured type, sandwiched between the two internal and external luminescent plates, so that the major bases of the respective trapezoidal sections face thereon at opposite sides thereof.

The device 1 further comprises conveying means configured, as will be described in detail hereinafter, so as to gather and concentrate the luminous radiation inside the above-introduced ring-like concentrator 2.

The conveying means comprises, in the preferred -embodiment shown herein, a conveyor 3 arranged along the external periphery of the ring.

The photovoltaic device 1 is preferably inserted into a container 4 and is supported therein by a coupling system (not depicted). In particular, the container 4 is closed topwise by four Fresne I-type lenses (of which only two are visible in the figure), denoted by reference number 5 in the figure, arranged so as to form a circle in which each lens takes up a respective quadrant.

Fresnel-type lenses are known to a person skilled in the art, therefore the principles underlying their operation will not be described hereinafter.

The Fresnel lenses 5 cooperate, as will be described hereinafter, with the conveyor 3 so as to concentrate thereon a solar radiation in turn incident on them.

Referring now to next Figure 2, a section of the ring-like concentrator 2 is shown in a front view. In figure 2, a wall of the container 4, closed topwise by the Fresnel lens 5, a section of the solar concentrator 2 and the conveyor 3 are visible. It is understood that what described with regard to the section of the concentrator 2 of Figure 2 applies absolutely analogously to all concentrator sections.

Incident radiation arrives on the Fresnel lens 5, which is configured so as to convey and concentrate said radiation on a portion of the conveyor 3.

In particular, as visible in the figure, the conveyor 3 has a triangular section, and takes the form of an extension of the luminescent plate 22, of which it is an integral part, on a side 31 thereof, and has a face 32 arranged so as to gather the incident solar radiation, passed through the Fresnel lens 5. Preferably, the conveyor 3 has an isosceles right-angled triangle-shaped section, and comprises a third oblique face 33, mirror-fitted and opposite to said first and second face 31 and 32.

The external luminescent plate 22 has a receiving surface 221, configured just to receive solar radiation, obtained along its external periphery, and precisely at the minor base of its trapezoidal section.

The triangular conveyor 3 is intended to be connected to the concentrator at the receiving surface 221. In order to make its construction easier, its face 31 faces on the receiving surface 221.

Therefore, incident radiation passing through the Fresnel lens 5 is channeled on a portion of the face 32 of the conveyor 3 equipped with anti-reflex film to prevent dispersion of rays, and concentrated thereat.

By means of its configuration and of the mirror-fitted oblique face 33, all radiation incident on the Fresnel lens, and conveyed therefrom on the triangular conveyor 3, is transferred in the external luminescent plate 22.

The external luminescent plate 22 is configured so as to absorb a part of incident radiation having a frequency in the ultraviolet field, thanks to the luminescent substances dissolved therein, and emit a first radiation to the semiconductor layer 23 at a frequency such as to produce photoelectric effect.

Otherwise, the internal luminescent plate 21 is configured so as to absorb a part of incident radiation having a frequency in the infrared field, thanks to the luminescent substances dissolved therein, and emit a second radiation to the conductor layer 23 at a frequency such as to produce photoelectric effect.

More specifically, that part of radiation having a frequency in the infrared field crosses the external luminescent plate 22 without being processed, and by crossing the semiconductor layer 23 arrives into the internal luminescent plate 21, which is such as to absorb it and re-emit it again to the semiconductor layer at the correct frequency to trigger just the photoelectric effect.

Preferably, the semiconductor layer 23 has a horseshoe-type configuration, comprising an external portion of P-doped silicon having a substantially upturned U-like shape, and an internal portion of N-doped silicon, both nanostructured. Bottomwise, the required electrical-type connections are obtained for transporting electric energy created by photoelectric effect, so as to power-supply a user load (not depicted).

Preferably, the luminescent conveyors 3, 21 and 22 are made of polymethyl methacrylate (PMMA), obtainable by a polymerization of a mixture of plexit 55 combined with a layer of PE 399 Kristalflex.

The external luminescent plate 22 comprises substances selected so that it collects, as mentioned, solar radiation in the ultraviolet field. The selection of substances and their amounts to obtain the described effect is deemed to be within the reach of a technician in the field, therefore they will not be described hereinafter.

The internal luminescent plate 21 comprises instead a selection of substances such as to receive radiation in the infrared field. They could comprise, by way of example and not for limitative purposes, a mixture of lumogen F Red 305 (0.01% by weight) and of Fluorescence Yellow CRS040 (0.003% by weight).

Advantageously, the internal 21 and external 22 luminescent plates internally comprise, besides luminescent substances, also pigmen ts apt to produce a phosphorescent effect, like, by way of example, the pigment of "Yellow green pigment" type.

The presence of such pigments enables night-time activity of the device 1, which is able to continue producing electricity by releasing to the silicon layer solar radiation accumulated during the day, by just the action of such phosphorescent pigments. In this case as well, the knowledge and the technical contrivances needed for the manufacturing of the luminescent conveyor having such phosphorescence properties are deemed to be within the reach of a technician in the field, therefore these aspects will not be further described hereinafter.

To maximize transmission of radiation emitted by conveyors 3, 21 and 22 to the silicon layer, the concentrator 1 is advantageously equipped with reflecting strips so that part of the solar radiation upon reaching the inside of the concentrator does not scatter to the outside, thereby considerably increasing the efficiency of the photovoltaic device subject-matter of the present invention.

In particular, the external luminescent plate 22 comprises a pair of reflecting strips 222 and 223, each obtained on a respective oblique side. The internal luminescent plate 21 comprises, likewise, a pair of reflecting strips 211 and 212, obtained each along a respective oblique side, and further comprises a reflecting strip 213 arranged along an external surface thereof located along the minor base of its trapezoidal section.

To further improve the efficiency of the device 1 and guarantee that the incident radiation be all actually used to trigger photoelectric effect, the concentrator 2 comprises four hemispheric covers, denoted by reference number 7, of which three arranged along a respective side of the ring and one placed along the top side of the ring.

The covers may also be advantageously used as structural member for supporting the concentrator 2 inside the container 4.

Always referring to Figure 2, the photovoltaic device further comprises a cooling system associated to the concentrator 2. Preferably, channels provided with coolant are obtained inside the hemispheric covers 7. By way of example, in the figure channels denoted by reference number 10 are shown.

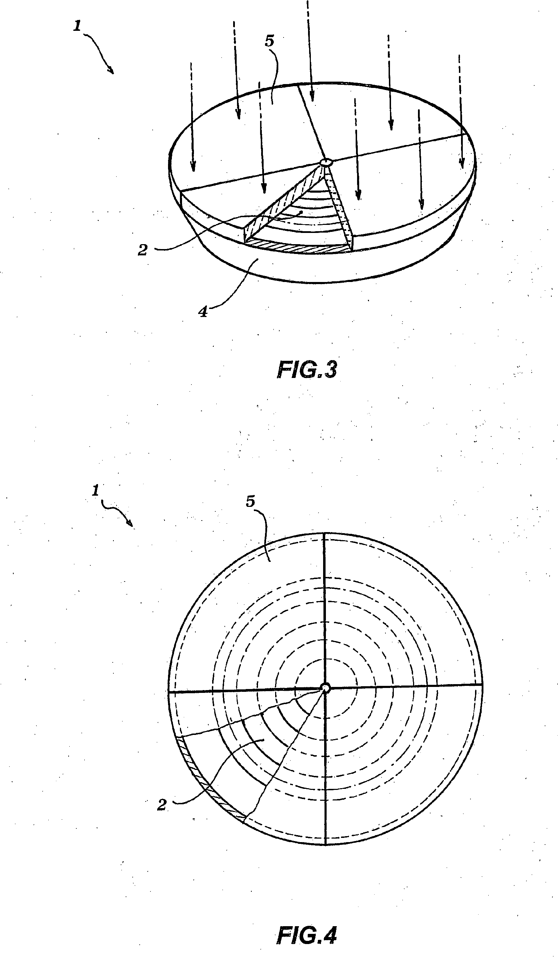

Referring now to Figures 3 and 4, the photovoltaic device 1 is shown respectively in a perspective view and in a plan view, comprising the concentrator 2 (visible through a cross-section of the Fresnel lenses) inserted and supported inside the container 4 closed topwise by the Fresnel lenses 5.

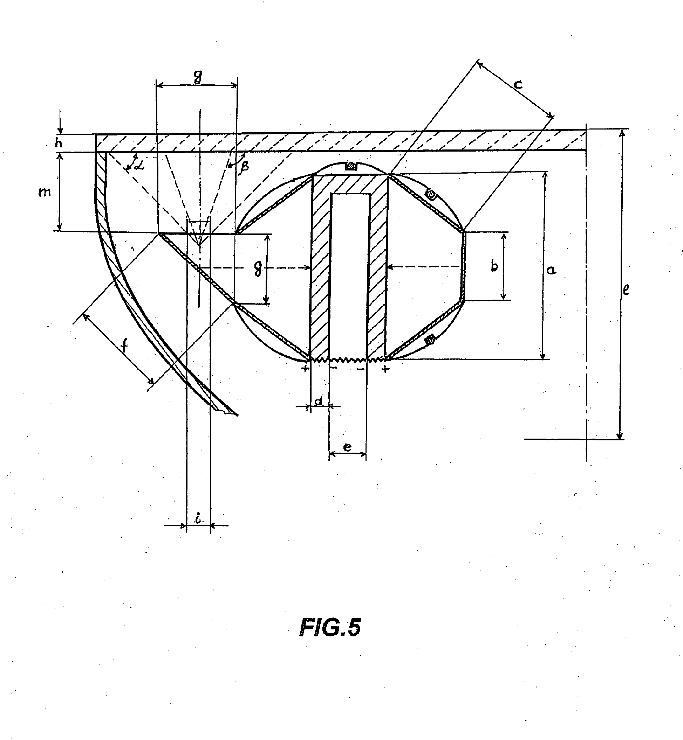

Referring to Figure 5, by way of example and not for limitative purposes, a preferred geometry for the embodiment shown herein is provided. In particular, the letters reported hereinafter refer to the letters indicated in the drawing, each of which characterizing a respective quantity (lengths or angles).
a: 3 cm
b: 2 cm
c: 1.1 cm
d: 0.1 cm
e: 0.3 cm
f: 3.0 cm
g: 2.0 cm
h: 0.5 cm
i: 1.0 cm
l: 5.5 cm
Angle α: 24°
Angle β: 55°
Internal diameter of the ring: 5.5 cm
External diameter of the ring: 9.5 cm
Ring height: 3.0 cm

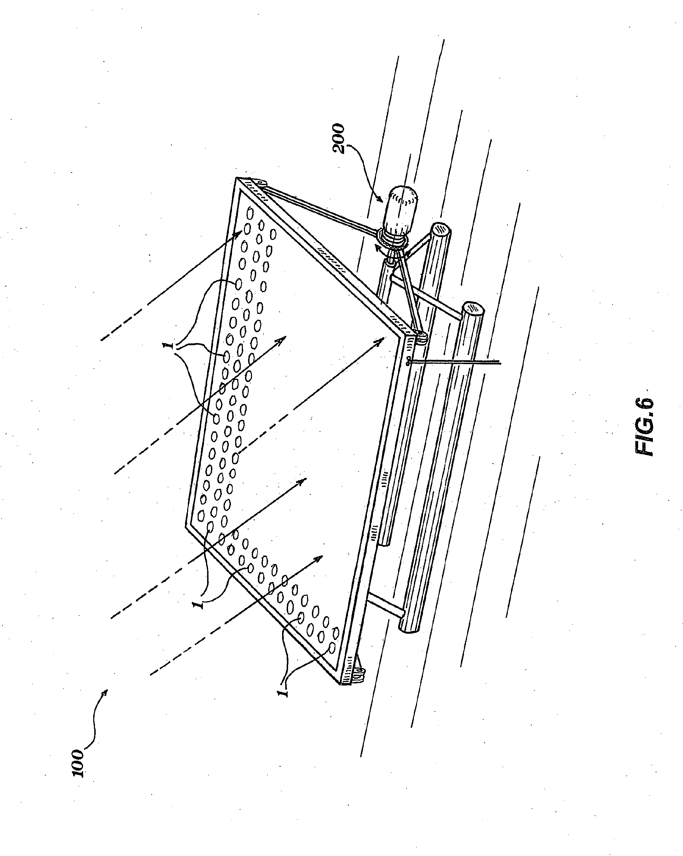

Lastly, referring to the last figure 6, a photovoltaic panel 100 is depicted, comprising a plurality of photovoltaic devices 1, arranged at nodes of a lattice structure. The photovoltaic panel 100 further comprises a sun-following moving system, denoted in figure by reference number 200, apt to move the panel so as to collect at any instant the maximum solar radiation possible.

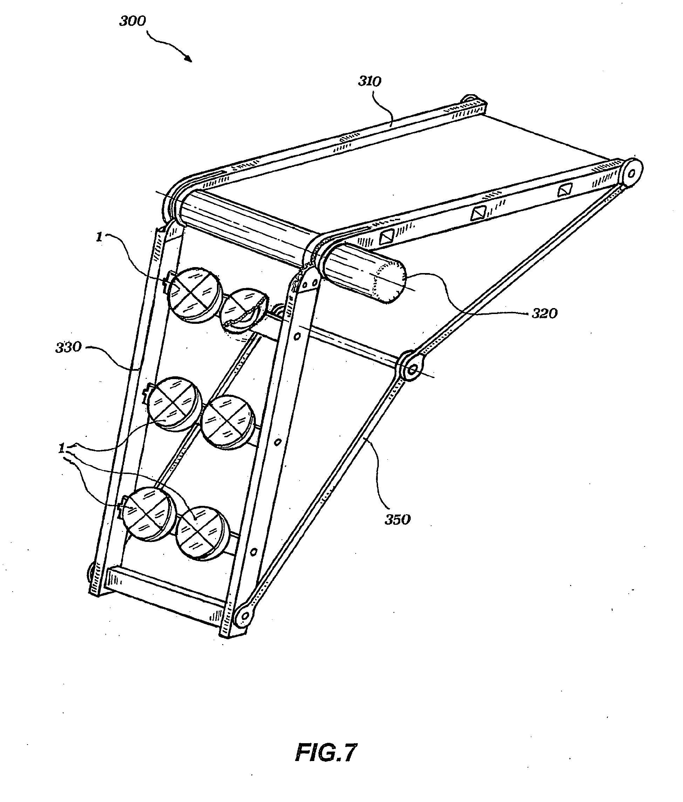

In figure 7 a photovoltaic panel 300 according to a variant embodiment is shown.

In particular, always referring to Figure 7, the panel 300 comprises a support structure 310 having, in the embodiment set forth herein by way of example and not for limitative purposes, a pair of uprights, apt to be fixed, e.g., to balconies or building protrusions. The aforedescribed photovoltaic devices 1 are in turn fixed on a load-bearing structure 330, which is hinged to the support structure 310 and is therefore free to rotate with respect thereto by a mechanism of "retractable" type.

Rotation of the load-bearing structure 330 is attained by an electric motor, denoted in figure by reference number 320, which enables precisely to tilt needwise such structure 330 with respect to a plane defined by the two uprights 310.

Preferably, the electric motor 320 is power-supplied by a portion of solar energy processed by the panel itself.

The panel 300 further comprises, to attain greater structural rigidity in order to provide solidity in case of atmospheric agents such as wind and rain, articulated safety rods , denoted in figure by number reference 350, connecting the load-bearing structure 330 to the support structure 310.

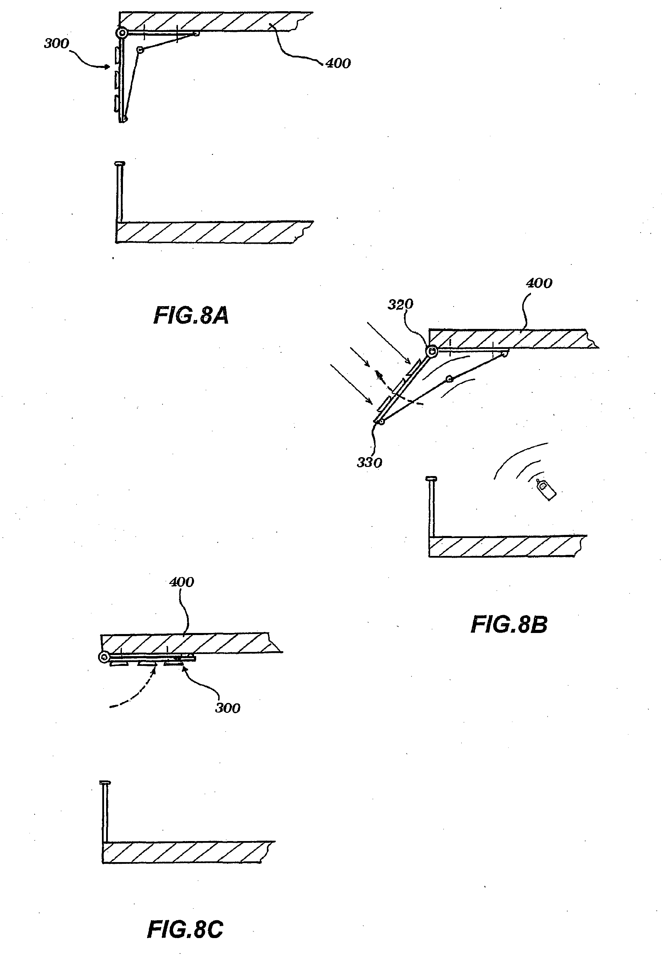

Referring now to the sequence of Figures 8A - 8C, a photovoltaic panel 300 is shown coupled to a building protrusion, schematically depicted in figure and denoted by reference number 400.

As can be seen in the figures, the load-bearing structure is set in motion by the motor 320 (e.g., driven by a remote control) and is oriented so as to optimize its absorption of solar radiation.

In figure 8C, the panel 300 is shown in a retracted configuration, therefore such as not to be visible when not in use.

The necessary knowledge and the technical contrivances required to implement such a moving system are deemed to be widely known to a person skilled in the art, therefore a detailed description thereof will be omitted.

The present invention has hereto been described with reference to a preferred embodiment thereof. It is understood that other embodiments might exist, all falling within the concept of the same invention, and all comprised within the protective scope of the claims hereinafter.

## Claims

1. A photovoltaic device (1) comprising:
• a solar concentrator (2) having a ring-like shape, in turn comprising:
▪ an external conveyor (3) arranged along an external portion of the ring;
▪ an external luminescent plate (22) having a trapezoidal section and having an external peripheral receiving surface (221) configured to receive a luminous radiation incident and coming from the conveyor (3);
▪ an internal luminescent plate (21) arranged along an internal portion of the ring and having a trapezoidal section;
▪ a nanostructured semiconductor layer (23) sandwiched between the two plates (21, 22) so that the major bases of the respective trapezoidal sections face thereon, said semiconductor layer (23) being configured to receive a radiation transmitted by the external and internal plates (21, 22) and produce photovoltaic effect;
• conveying means (3, 5), configured to gather and concentrate the incident luminous radiation at said peripheral receiving surface (221).

2. The photovoltaic device (1) according to the preceding claim, wherein said external luminescent plate (22) is configured so as to absorb a part of incident radiation having a frequency in the ultraviolet field, and emit a first radiation to the semiconductor layer (23) at a frequency such as to produce photoelectric effect.

3. The photovoltaic device (1) according to one of the preceding claims, wherein said internal luminescent plate (21) is configured so as to absorb a part of incident radiation having a frequency in the infrared field, and emit a second radiation to the semiconductor layer (23) at a frequency such as to produce photoelectric effect.

4. The photovoltaic device (1) according to one of the preceding claims, wherein said nanostructured semiconductor layer (23) has a horseshoe-type configuration, comprising an external portion of P-doped silicon having a substantially upturned U-like shape, and an internal portion of N-doped silicon.

5. The photovoltaic device (1) according to any one of the preceding claims, wherein said conveying means (3, 5) comprises a conveyor (3) arranged along the external periphery of the ring and having a triangular section, having a first face (31) appendage of said external luminescent plate (22) along said peripheral receiving surface (221) and a second face (32) configured to gather and convey the incident radiation.

6. The photovoltaic device (1) according to the preceding claims, wherein said conveyor (3) has an isosceles right-angled triangle section, comprising a third mirror-fitted oblique face (33), opposite to said first and second face (31, 32).

7. The photovoltaic device (1) according to claims 5 or 6, wherein said conveyor (3) is made of polymethyl methacrylate, obtainable from a mixture of plexit 55 combined with a layer of PE 399 Kristalflex or other anti-reflex film onto its receiving face (32).

8. The photovoltaic device (1) according to one of the claims 5 to 7, wherein said conveying means (3, 5) comprises one or more Fresnel-type lenses (5), overlapped to and spaced apart from said conveyor (3) and arranged so as to concentrate the luminous radiation incident thereon to the latter.

9. The photovoltaic device (1) according to claims 8 and 6, comprising four Fresnel lenses (5), arranged thereamong so as to form a circle in which each lens takes up a respective quadrant thereof, each Fresnel lens (5) being apt to concentrate the incident radiation at the respective second face portion (32) subjected thereto of said conveyor (3).

10. The photovoltaic device (1) according to any one of the preceding claims, wherein said external and internal luminescent plates (22, 21) are made of polymethyl methacrylate, obtainable from a mixture of plexit 55.

11. The photovoltaic device (1) according to any one of the preceding claims, wherein said external luminescent plate (22) comprises a pair of external reflecting strips (222, 223) arranged each along a respective oblique side.

12. The photovoltaic device (1) according to any one of the preceding claims, wherein said internal luminescent plate (21) comprises a pair of internal reflecting strips (211, 212) arranged each along a respective oblique side and a reflecting strip (213) arranged along the minor base of the trapezoidal section thereof.

13. The photovoltaic device (1) according to any one of the preceding claims, wherein said external and internal luminescent plates (22, 21) internally comprise pigments apt to produce a phosphorescent effect.

14. The photovoltaic device (1) according to the preceding claim, wherein said pigments are of "Yellow - green" type.

15. The photovoltaic device (1) according to claims 11 and 12, comprising four hemispheric covers (7), each arranged on a respective side of the ring.

16. The photovoltaic device (1) according to any one of the preceding claims, further comprising a cooling system associated to said solar concentrator (2).

17. The photovoltaic device (1) according to the preceding claim, wherein said cooling system comprises one or more cooling channels (10) provided with coolant.

18. The photovoltaic device (1) according to claims 15 and 17, wherein said cooling channels (10) are obtained inside said hemispheric covers (7).

19. The photovoltaic device (1) according to claim 9 and any one of the preceding claims, comprising a container (4) inside which it is inserted and supported, said container (4) being closed topwise by said four Fresnel lenses (5) arranged in circle.

20. A photovoltaic panel (100), comprising a plurality of photovoltaic devices (1) according to any one of the preceding claims, arranged at nodes of a retractable-type lattice structure.

21. The photovoltaic panel (100), according to the preceding claim, further comprising a sun-following moving system (200).

## Patentansprüche

1. Photovoltaikvorrichtung (1), die umfasst:
• einen Strahlungsbündler (2), der über eine ringähnliche Form verfügt, der seinerseits umfasst:
▪ einen externen Übertrager (3), der entlang eines externen Teils des Rings angeordnet ist;
▪ eine externe Leuchtplatte (22), die über einen trapezförmigen Abschnitt und eine externe periphere Empfängeroberfläche (221) verfügt, die geeignet ist, eine einfallende Lichtstrahlung zu empfangen, die von dem Übertrager (3) kommt;
▪ eine interne Leuchtplatte (21), die entlang eines internen Teils des Rings angeordnet ist und über einen trapezförmigen Abschnitt verfügt;
▪ eine nanostrukturierte Halbleiterschicht (23), die zwischen den zwei Platten (21, 22) eingeschlossen ist, so dass sich die größeren Basen der jeweiligen trapezförmigen Abschnitte darauf gegenüberliegen, wobei die Halbleiterschicht (23) geeignet ist, eine Strahlung zu empfangen, die durch die externen und internen Platten (21, 22) übertragen wird und einen photovoltaischen Effekt zu erzeugen;
• Übertragungsmittel (3, 5), die geeignet sind die einfallende Lichtstrahlung bei der peripheren Empfängeroberfläche (221) zu sammeln und zu konzentrieren.

2. Photovoltaikvorrichtung (1) gemäß dem vorangehenden Anspruch, wobei die externe Leuchtplatte (22) geeignet ist, einen Teil einer einfallenden Strahlung zu absorbieren, der über eine Frequenz im ultravioletten Bereich verfügt, und eine erste Strahlung an die Halbleiterschicht (23) bei einer Frequenz zu emittieren, um einen photoelektrischen Effekt zu erzeugen.

3. Photovoltaikvorrichtung (1) gemäß einem der vorangehenden Ansprüche, wobei die interne Leuchtplatte (21) geeignet ist, einen Teil einer einfallenden Strahlung zu absorbieren, der über eine Frequenz im infraroten Bereich verfügt, und eine zweite Strahlung an die Halbleiterschicht (23) bei einer Frequenz zu emittieren, um einen photoelektrischen Effekt zu erzeugen.

4. Photovoltaikvorrichtung (1) gemäß einem der vorangehenden Ansprüche, wobei die nanostrukturierte Halbleiterschicht (23) über eine hufeisenähnliche Konfiguration verfügt, die umfasst: einen externen Teil aus P-dotiertem Silizium, der über eine im Wesentlichen nach oben gewandte U-ähnliche Form verfügt, und einen internen Teil aus N-dotiertem Silizium.

5. Photovoltaikvorrichtung (1) gemäß einem der vorangehenden Ansprüche, wobei das Übertragungsmittel (3, 5) umfasst: einen Übertrager (3), der entlang der externen Peripherie des Rings angeordnet ist und über einen dreieckigen Abschnitt verfügt, der über ein erstes Seitenanhängsel (31) der externen Leuchtplatte (22) entlang der peripheren Empfängeroberfläche (221) und eine zweite Seite (32) verfügt, die geeignet ist, die einfallende Strahlung zu sammeln und zu übertragen.

6. Photovoltaikvorrichtung (1) gemäß den vorangehenden Ansprüchen, wobei der Übertrager (3) über einen gleichschenkligen rechtwinkligen Dreiecksabschnitt verfügt, der eine dritte spiegeltaugliche schräge Seite (33) gegenüber der ersten und zweiten Seite (31, 32) umfasst.

7. Photovoltaikvorrichtung (1) gemäß den Ansprüchen 5 oder 6, wobei der Übertrager (3) aus Polymethylmethacrylat besteht, erhältlich aus einer Mischung von Plexit 55 in Kombination mit einer Schicht aus Krystalflex PE 399 oder einem anderen Antireflexfilm auf seiner Empfängerseite (32).

8. Photovoltaikvorrichtung (1) gemäß einem der Ansprüche 5 bis 7, wobei das Übertragungsmittel (3, 5) eine oder mehrere Fresnel-ähnliche Linsen (5) umfasst, die den Übertrager (3) überlappen und mit Abstand zu dem Übertrager (3) angeordnet sind und so angeordnet sind, dass sie die darauf einfallende Lichtstrahlung auf das Letztere konzentrieren.

9. Photovoltaikvorrichtung (1) gemäß den Ansprüchen 8 und 6, die umfasst: vier Fresnel-Linsen (5), die untereinander so angeordnet sind, dass sie einen Kreis bilden, in dem jede Linse einen jeweiligen Quadraten davon ausmacht, wobei jede Fresnel-Linse (5) geeignet ist, die einfallende Strahlung bei dem jeweiligen zweiten Seitenteil (32) von dem Übertrager (3) zu konzentrieren, das ihr ausgesetzt wird.

10. Photovoltaikvorrichtung (1) gemäß einem der vorangehenden Ansprüche, wobei die externen und internen Leuchtplatten (22, 21) aus Polymethylmethacrylat bestehen, erhältlich aus einer Mischung von Plexit 55.

11. Photovoltaikvorrichtung (1) gemäß einem der vorangehenden Ansprüche, wobei die externe Leuchtplatte (22) ein Paar externer reflektierender Streifen (222, 223) umfasst, die jeweils entlang einer entsprechenden schrägen Seite angeordnet sind.

12. Photovoltaikvorrichtung (1) gemäß einem der vorangehenden Ansprüche, wobei die interne Leuchtplatte (21) umfasst: ein Paar interner reflektierender Streifen (211, 212), die jeweils entlang einer entsprechenden schrägen Seite angeordnet sind, und einen reflektierenden Streifen (213), der entlang der kleineren Basis des trapezförmigen Abschnitts davon angeordnet ist.

13. Photovoltaikvorrichtung (1) gemäß einem der vorangehenden Ansprüche, wobei die externen und internen Leuchtplatten (22, 21) intern Pigmente umfassen, die geeignet sind einen phosphoreszierenden Effekt zu erzeugen.

14. Photovoltaikvorrichtung (1) gemäß dem vorangehenden Anspruch, wobei die Pigmente von einer "Gelb-Grün"-Art sind.

15. Photovoltaikvorrichtung (1) gemäß den Ansprüchen 11 und 12, die vier halbkugelige Abdeckungen (7) umfasst, die jeweils auf einer entsprechenden Seite des Rings angeordnet sind.

16. Photovoltaikvorrichtung (1) gemäß einem der vorangehenden Ansprüche, die weiterhin ein Kühlsystem umfasst, das mit dem Solarkonzentrierer (2) verknüpft ist.

17. Photovoltaikvorrichtung (1) gemäß dem vorangehenden Anspruch, wobei das Kühlsystem einen oder mehrere Kühlkanäle (10) umfasst, die mit einem Kühlmittel ausgestattet sind.

18. Photovoltaikvorrichtung (1) gemäß den Ansprüchen 15 und 17, wobei die Kühlkanäle (10) innerhalb der halbkugeligen Abdeckungen (7) erhalten werden.

19. Photovoltaikvorrichtung (1) gemäß Anspruch 9 und einem der vorangehenden Ansprüche, die einen Behälter (4) umfasst, in dem sie eingesetzt und unterstützt wird, wobei der Behälter (4) oben durch die vier in einem Kreis angeordneten Fresnel-Linsen (5) geschlossen ist.

20. Photovoltaikpaneel (100), das umfasst: eine Mehrzahl von Photovoltaikvorrichtungen (1) gemäß einem der vorangehenden Ansprüche, die bei Knoten einer einziehbaren Gitterstruktur angeordnet sind.

21. Photovoltaikpaneel (100) gemäß dem vorangehenden Anspruch, das weiterhin ein Bewegungssystem (200) umfasst, das der Sonne folgt.

## Revendications

1. Dispositif photovoltaïque (1) comprenant :
un concentrateur solaire (2) ayant une forme annulaire, comprenant :
un transporteur externe (3) agencé le long d'une partie externe de l'anneau ;
une plaque luminescente externe (22) ayant une section trapézoïdale et ayant une surface de réception périphérique externe (221) configurée pour recevoir un rayonnement lumineux incident et provenant du transporteur (3) ;
une plaque luminescente interne (21) agencée le long d'une partie interne de l'anneau et ayant une section trapézoïdale ;
une couche de semi-conducteur nanostructurée (23) prise en sandwich entre les deux plaques (21, 22) de sorte que les bases majeures des sections trapézoïdales respectives font face à ces dernières, ladite couche de semi-conducteur (23) étant configurée pour recevoir un rayonnement transmis par les plaques interne et externe (21, 22) et produire l'effet photovoltaïque;
des moyens de transport (3, 5) configurés pour rassembler et concentrer le rayonnement lumineux incident au niveau de ladite surface de réception périphérique (221).

2. Dispositif photovoltaïque (1) selon la revendication précédente, dans lequel ladite plaque luminescente externe (22) est configurée pour absorber une partie du rayonnement incident qui a une fréquence dans le champ ultraviolet, et émettre un premier rayonnement vers la couche de semi-conducteur (23) à une fréquence telle qu'elle produit l'effet photoélectrique.

3. Dispositif photovoltaïque (1) selon l'une des revendications précédentes, dans lequel la plaque luminescente interne (21) est configurée pour absorber une partie du rayonnement incident qui a une fréquence dans le champ infrarouge, et émettre un second rayonnement vers la couche de semi-conducteur (23) à une fréquence telle qu'elle produit l'effet photoélectrique.

4. Dispositif photovoltaïque (1) selon l'une quelconque des revendications précédentes, dans lequel ladite couche de semi-conducteur nanostructurée (23) a une configuration en forme de fer à cheval, comprenant une partie externe de silicium dopé P ayant une forme en forme de U sensiblement retourné, et une partie interne de silicium dopé N.

5. Dispositif photovoltaïque (1) selon l'une quelconque des revendications précédentes, dans lequel lesdits moyens de transport (3, 5) comprennent un transporteur (3) agencé le long de la périphérie externe de l'anneau et ayant une section triangulaire, ayant un appendice de première face (31) de ladite plaque luminescente externe (22) le long de ladite surface de réception périphérique (221) et une seconde face (32) configurée pour rassembler et transporter le rayonnement incident.

6. Dispositif photovoltaïque (1) selon les revendications précédentes, dans lequel ledit transporteur (3) a une section triangulaire isocèle, comprenant une troisième face oblique montée sur miroir (33), opposée auxdites premier et deuxième faces (31, 32).

7. Dispositif photovoltaïque (1) selon les revendications 5 ou 6, dans lequel ledit transporteur (3) est réalisé à partir de polyméthacrylate de méthyle, pouvant être obtenu à partir d'un mélange de plexit 55 combiné avec une couche de Kristalflex PE 399 ou un autre film antireflet sur sa face de réception (32).

8. Dispositif photovoltaïque (1) selon l'une des revendications 5 à 7, dans lequel lesdits moyens de transport (3, 5) comprennent une ou plusieurs lentilles de type Fresnel (5) chevauchant sur et éloignées dudit transporteur (3) et agencées pour concentrer le rayonnement lumineux incident sur ce dernier.

9. Dispositif photovoltaïque (1) selon les revendications 8 et 6, comprenant quatre lentilles de Fresnel (5), agencées afin de former un cercle dans lequel chaque lentille adopte son quadrant respectif, chaque lentille de Fresnel (5) étant apte à concentrer le rayonnement incident au niveau de la deuxième partie de face (32) respective soumise à ce dernier dudit transporteur (3).

10. Dispositif photovoltaïque (1) selon l'une quelconque des revendications précédentes, dans lequel lesdites plaques luminescentes externe et interne (22, 21) sont réalisées à partir de polyméthacrylate de méthyle, pouvant être obtenu à partir d'un mélange de plexit 55.

11. Dispositif photovoltaïque (1) selon l'une quelconque des revendications précédentes, dans lequel ladite plaque luminescente externe (22) comprenant une paire de bandes réfléchissantes externes (222, 223), chacune agencée le long d'un côté oblique respectif.

12. Dispositif photovoltaïque (1) selon l'une quelconque des revendications précédentes, dans lequel ladite plaque luminescente interne (21) comprenant une paire de bandes réfléchissantes internes (211, 212), chacune agencée le long d'un côté oblique respectif et une bande réfléchissante (213) agencée le long de la base mineure de sa section trapézoïdale.

13. Dispositif photovoltaïque (1) selon l'une quelconque des revendications précédentes, dans lequel lesdites plaques luminescentes externe et interne (22, 21) comprennent intérieurement, des pigments aptes à produire un effet phosphorescent.

14. Dispositif photovoltaïque (1) selon la revendication précédente, dans lequel lesdits pigments sont du type « jaune-vert ».

15. Dispositif photovoltaïque (1) selon les revendications 11 et 12, comprenant quatre couvercles hémisphériques (7), chacun agencé sur un côté respectif de l'anneau.

16. Dispositif photovoltaïque (1) selon l'une quelconque des revendications précédentes, comprenant en outre un système de refroidissement associé audit concentrateur solaire (2).

17. Dispositif photovoltaïque (1) selon la revendication précédente, dans lequel ledit système de refroidissement comprend un ou plusieurs canaux de refroidissement (10) dotés de réfrigérant.

18. Dispositif photovoltaïque (1) selon les revendications 15 et 17, dans lequel lesdits canaux de refroidissement (10) sont obtenus à l'intérieur desdits couvercles hémisphériques (7).

19. Dispositif photovoltaïque (1) selon la revendication 9 et l'une quelconque des revendications précédentes, comprenant un contenant (4) à l'intérieur duquel il est inséré et supporté, ledit contenant (4) étant fermé sur le dessus par lesdites quatre lentilles de Fresnel (5) agencées en cercle.

20. Panneau photovoltaïque (100), comprenant une pluralité de dispositifs photovoltaïques (1) selon l'une quelconque des revendications précédentes, agencé au niveau des noeuds d'une structure en treillis de type rétractable.

21. Panneau photovoltaïque (100), selon la revendication précédente, comprenant en outre un système de déplacement qui suit le soleil (200).
